(19) Europäisches Patentamt / European Patent Office / Office européen des brevets

(11) **EP 4 527 971 A1**

(12) **EUROPEAN PATENT APPLICATION**
published in accordance with Art. 153(4) EPC

(43) Date of publication:
26.03.2025 Bulletin 2025/13

(21) Application number: 23807685.5

(22) Date of filing: 18.05.2023

(51) International Patent Classification (IPC):
*C23C 14/34* (2006.01)    *B22F 3/15* (2006.01)
*B22F 3/24* (2006.01)    *C22F 1/00* (2006.01)
*C22F 1/11* (2006.01)    *C22F 1/18* (2006.01)

(52) Cooperative Patent Classification (CPC):
B22F 3/15; B22F 3/24; C22F 1/00; C22F 1/11;
C22F 1/18; C23C 14/34

(86) International application number:
PCT/JP2023/018537

(87) International publication number:
WO 2023/224084 (23.11.2023 Gazette 2023/47)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 19.05.2022 JP 2022082420
02.09.2022 JP 2022140342

(71) Applicant: Tosoh Corporation
Yamaguchi 746-8501 (JP)

(72) Inventors:
• SHONO Daiki
Ayase-shi, Kanagawa 252-1123 (JP)
• MESUDA Masami
Ayase-shi, Kanagawa 252-1123 (JP)
• KONDO Taiga
Ayase-shi, Kanagawa 252-1123 (JP)

(74) Representative: Müller-Boré & Partner
Patentanwälte PartG mbB
Friedenheimer Brücke 21
80639 München (DE)

(54) **METALLIC SPUTTERING TARGET, PRODUCTION METHOD THEREFOR, AND METALLIC MATERIAL AND PRODUCTION METHOD THEREFOR**

(57)    Provided is at least one of a metal material including a metal having a body-centered cubic structure, the metal material being suitable as a sputtering target, a method for producing the metal material, a sputtering target including the metal material, and a method for producing a film, the method including using the sputtering target.

A metal material includes a metal having a body-centered cubic structure, in which with respect to a sum of orientation area fractions of a {001} plane, a {101} plane and a {111} plane, a ratio of the orientation area fraction of the {111} plane is 0.45 or more.

Fig. 1

**Description**

TECHNICAL FIELD

The present disclosure relates to a metal material suitable as a sputtering target and a method for producing the metal material, and a metal sputtering target comprising the metal material and a method for producing the metal sputtering target.

BACKGROUND ART

Metals having body-centered cubic structures, such as chromium and molybdenum, are used for light-shielding films for lithography masks and as film-forming materials for obtaining such films, such as sputtering targets. When a metal having a body-centered cubic structure is used as a sputtering target, sputtered particles deposit in the {111} plane direction, which is the closest-packed plane direction. Thus, if the ratio of the {111} plane is high, a sputtered film can be formed with higher efficiency by using a metal having a body-centered cubic structure as a sputtering target.

For example, it has been studied that a metal having a body-centered cubic structure is oriented in the {111} plane through repeated forging and rolling treatments (Patent Document 1).

PRIOR ART DOCUMENTS

PATENT DOCUMENTS

Patent Document 1: International Publication No. 2020/195121

DISCLOSURE OF INVENTION

TECHNICAL PROBLEM

In Patent Document 1, it has been studied that niobium, which is a metal having a body-centered cubic structure, is oriented in the {111} plane, but this method gives rise to a bias in the degree of orientation in the thickness direction, thus resulting in insufficient orientation in the {111} plane and non-uniform deformation of the surface and the interior, and cannot provide a metal material suitable as a film-forming material such as a sputtering target.

An object of the present disclosure is to provide at least one of a metal material comprising a metal having a body-centered cubic structure, the metal material being suitable as a sputtering target, a method for producing the metal material, a sputtering target comprising the metal material, and a method for producing a film, the method comprising using the sputtering target.

SOLUTION TO PROBLEM

Thus, the present invention is as defined in the claims, and the gist of the present disclosure is as follows.

[1] A metal material comprising a metal having a body-centered cubic structure, wherein with respect to a sum of orientation area fractions of a {001} plane, a {101} plane and a {111} plane, a ratio of the orientation area fraction of the {111} plane is 0.45 or more.

[2] A metal material comprising a metal having a body-centered cubic structure, wherein with respect to a sum of orientation area fractions of a {001} plane, a {101} plane and a {111} plane, a ratio of the orientation area fraction of the {111} plane is 0.60 or more.

[3] The metal material according to [1] or [2], wherein the orientation area fraction of the {111} plane of the metal is 20% or more.

[4] The metal material according to any one of [1] to [3], wherein the orientation area fraction of the {111} plane of the metal is 80% or more.

[5] The metal material according to any one of [1] to [4], wherein the orientation area fraction of the {001} plane of the metal is 20% or less.

[6] The metal material according to any one of [1] to [5], wherein the orientation area fraction of the {001} plane of the metal is 5% or less.

[7] The metal material according to any one of [1] to [6], wherein the metal has an average grain size of 200 $\mu$m or less.

[8] The metal material according to any one of [1] to [7], wherein the metal having a body-centered cubic structure is at least one selected from the group consisting of chromium (Cr), iron (Fe), rubidium (Ru), niobium (Nb), molybdenum

EP 4 527 971 A1

(Mo), tantalum (Ta), vanadium (V) and tungsten (W).

[9] A method for producing the metal material according to any one of [1] to [8], the method comprising a pressurization step of performing a pressurization treatment on an ingot formed of a metal having a body-centered cubic structure at a pressurizing temperature of 500°C or higher and a pressurizing rate of less than 15 mm/s to obtain a processed ingot, and a heat treatment step of treating the processed ingot at 850°C or higher.

[10] The production method according to [9], wherein the pressurization treatment in the pressurization step is performed twice or more.

[11] A sputtering target comprising the metal material according to any one of [1] to [8].

[12] A method for producing a film, the method comprising using a sputtering target comprising the metal material according to any one of [1] to [8].

ADVANTAGEOUS EFFECTS OF INVENTION

The present disclosure can provide at least one of a metal material comprising a metal having a body-centered cubic structure, the metal material being suitable as a sputtering target, a method for producing the metal material, a sputtering target comprising the metal material, and a method for producing a film, the method comprising using the sputtering target.

BRIEF DESCRIPTION OF DRAWINGS

[Fig. 1] Fig. 1 is an optical microscopic observation image (magnification: 200×) of a section of a chromium material of Example 1.

[Fig. 2] Fig. 2 is an optical microscopic observation image (magnification: 200×) of a section of a molybdenum material of Example 6.

DESCRIPTION OF EMBODIMENTS

The present disclosure will be described in detail with reference to an embodiment.

<Metal Material>

The present embodiment is a metal material comprising a metal having a body-centered cubic structure, wherein with respect to a sum of orientation area fractions of a {001} plane, a {101} plane and a {111} plane, a ratio of the orientation area fraction of the {111} plane is 0.45 or more. The present embodiment relates to a metal material comprising a metal having a body-centered cubic structure, and may be a metal material formed of a metal having a body-centered cubic structure (hereinafter also referred to as a "bcc metal") or a metal material constituted by the bcc metal. The bcc metal facilitates orientation in the {111} plane.

For <111> slip at high temperature to readily occur, the bcc metal is preferably at least one selected from the group consisting of chromium (Cr), iron (Fe), rubidium (Ru), niobium (Nb), molybdenum (Mo), tantalum (Ta), vanadium (V) and tungsten (W), more preferably at least one selected from the group consisting of chromium, molybdenum, vanadium and tungsten, still more preferably at least one selected from the group consisting of chromium, molybdenum and tungsten, yet more preferably at least one of chromium and molybdenum, particularly preferably chromium.

The bcc metal may be an alloy, and the alloy constituting the metal material according to the present embodiment may be, for example, an alloy containing at least one selected from the group consisting of chromium, iron, rubidium, niobium, molybdenum, tantalum, vanadium and tungsten, an alloy containing at least one selected from the group consisting of chromium, molybdenum, tantalum, vanadium and tungsten, an alloy containing at least one selected from the group consisting of chromium, molybdenum and tungsten, an alloy containing chromium and molybdenum, an alloy containing chromium or a chromium-molybdenum alloy.

Hereinafter, the metal material according to the present embodiment is also referred to as, for example, a "chromium material" when the bcc metal of the metal material is chromium or a "chromium-molybdenum material" when the bcc metal of the metal material is a chromium-molybdenum alloy.

In the bcc metal, the ratio of the orientation area fraction of the {111} plane with respect to the sum of the orientation area fractions of the {001} plane, the {101} plane and the {111} plane is 0.45 or more, preferably 0.50 or more, 0.60 or more, 0.75 or more or 0.95 or more. If a metal material including a bcc metal in which the ratio of the orientation area fraction of the {111} plane with respect to the sum of the orientation area fractions of the {001} plane, the {101} plane and the {111} plane (hereinafter also referred to as the "orientation area fraction ratio") is less than 0.45 is used as a sputtering target (hereinafter also referred to simply as a "target"), the percentage of sputtered particles stacked on a substrate will be significantly low, resulting in significantly low deposition efficiency. An orientation area fraction ratio of 0.45 or more makes the bcc metal have what is called a {111} orientation. In particular, for the chromium material, the orientation area fraction ratio is preferably 0.50 or more, and for the molybdenum material, the orientation area fraction ratio is preferably 0.60 or more, 0.75 or more or 0.95 or more.

The orientation area fraction ratio of the bcc metal included in the metal material according to the present embodiment is preferably high, and may be, for example, 1.0 or less, less than 1.0 or 0.99 or less. The upper limit and the lower limit of the orientation area fraction ratio may be in any combination. The orientation area fraction ratio is preferably 0.50 or more and 1.0 or less, more preferably 0.60 or more and 1.0 or less, still more preferably 0.75 or more and less than 1.0.

For the same reason as the orientation area fraction ratio, the orientation area fraction of the {111} plane (hereinafter also referred to as the "orientation area fraction$_{\{111\}}$") of the bcc metal is preferably 20% or more, more preferably 25% or more, 30% or more, 50% or more or 80% or more. In particular, for the chromium material, the orientation area fraction$_{\{111\}}$ is preferably 20% or more, 25% or more or 30% or more, and for the molybdenum material, the orientation area fraction$_{\{111\}}$ is preferably 50% or more or 80% or more. The orientation area fraction$_{\{111\}}$ may be 100% or less, less than 100%, 95% or less or 90% or less. For the chromium material, the orientation area fraction$_{\{111\}}$ is preferably 20% or more and 100% or less, more preferably 25% or more and 100% or less, still more preferably 30% or more and less than 100%. For the molybdenum material, the orientation area fraction$_{\{111\}}$ is preferably 50% or more and 100% or less, more preferably 80% or more and 100% or less, still more preferably 80% or more and less than 100%.

The orientation area fraction of the {001} plane (hereinafter also referred to as the "orientation area fraction$_{\{001\}}$") of the bcc metal is preferably smaller than the orientation area fraction$_{\{111\}}$, more preferably 20% or less, 15% or less, 10% or less or 5% or less. In particular, for the chromium material, the orientation area fraction$_{\{001\}}$ is preferably 15% or less, and for the molybdenum material, the orientation area fraction$_{\{001\}}$ is preferably 15% or less or 5% or less. The orientation area fraction$_{\{001\}}$ may be, for example, 1% or more or 2% or more. For the chromium material, the orientation area fraction$_{\{001\}}$ is preferably 1% or more and 15% or less, more preferably 2% or more and 15% or less. For the molybdenum material, the orientation area fraction$_{\{001\}}$ is preferably 1% or more and 15% or less, preferably 2% or more and 5% or less.

The orientation area fraction of the {101} plane (hereinafter also referred to as the "orientation area fraction$_{\{101\}}$") of the bcc metal is more preferably 15% or less, 10% or less, 5% or less or 2% or less. In particular, for the chromium material, the orientation area fraction$_{\{101\}}$ is preferably 10% or less, and for the molybdenum material, the orientation area fraction$_{\{101\}}$ is preferably 5% or less or 2% or less. The orientation area fraction$_{\{101\}}$ may be, for example, 0% or more, 0.01% or more, 0.10% or more or 1% or more. For the chromium material, the orientation area fraction$_{\{101\}}$ is preferably 0% or more and 10% or less, more preferably 0.10% or more and 10% or less. For the molybdenum material, the orientation area fraction$_{\{101\}}$ is preferably 0% or more and 5% or less, preferably 0.10% or more and 2% or less.

For each of the orientation area fraction ratio, the orientation area fraction$_{\{111\}}$, the orientation area fraction$_{\{001\}}$ and the orientation area fraction$_{\{101\}}$, the upper limit and the lower limit may be in any combination described above.

In the present embodiment, the orientation area fractions of crystal planes can be determined from an SEM observation image obtained by a scanning electron microscope-electron backscatter diffraction (hereinafter also referred to as "SEM-EBSD") measurement under the following conditions.

Observation magnification: 10×
Acceleration voltage condition: acceleration voltage, 20 kV
Applied current: 100 $\mu$A
Working distance: 10 mm
Step size: 5 $\mu$m

Specifically, an SEM observation image is divided into 5 $\mu$m × 5 $\mu$m unit cells to determine lattice points, which are used as measurement points. The orientation planes and the areas thereof at all the measurement points are measured, and the orientation area fractions may be determined from the following formulae.

Orientation area fraction$_{\{111\}}$ [%]

= {total area of measurement points oriented in {111} plane/total area of all

measurement points} × 100

Orientation area fraction$_{\{101\}}$ [%]

= {total area of measurement points oriented in {101} plane/total area of all measurement points} × 100

Orientation area fraction$_{\{001\}}$ [%]

= {total area of measurement points oriented in {001} plane/total area of all measurement points} × 100

Orientation area fraction ratio

= orientation area fraction$_{\{111\}}$/(orientation area fraction$_{\{111\}}$ + orientation area fraction$_{\{101\}}$ + orientation area fraction$_{\{001\}}$)

The SEM observation and the measurement of the orientation planes and the areas thereof may be performed using a commonly used SEM-EBSD apparatus (e.g., JSM-IT800 manufactured by JEOL Ltd.) and measurement/analysis programs (e.g., AZtec and AZtec Crystal) attached thereto.

Prior to the SEM-EBSD measurement, a measurement sample (metal material) may be pretreated by mirror polishing using SiC polishing paper and buffing, followed by electrolytic etching using a 5 vol% aqueous sulfuric acid solution.

The average KAM value of the bcc metal is preferably 2° or less, 1° or less or 0.5° or less. This helps reduce the strain in the metal material. The average KAM value is preferably 0° or more or 0.1° or more. The average KAM value is preferably 0° or more and 2° or less, more preferably 0° or more and 1° or less, still more preferably 0.1° or more and 0.5° or less.

The average KAM value in the present embodiment is an index that indicates a local change in crystal orientation, and is an average value of local misorientations (Kernel Average Misorientations; hereinafter also referred to as "KAM values") obtained by the SEM-EBSD measurement described above.

The KAM value is a value determined from the following formula.

[Math. 1]

$$\text{KAM value } [°] = \left(\sum_{j=1}^{n} \alpha_{ij}\right) \Big/ n$$

In the above formula, $\alpha_{ij}$ is a crystal misorientation between a measurement point i and a measurement point j. n is the total number of measurement points (adjacent measurement points) adjacent to a measurement point (target measurement point) where the KAM value is measured. A crystal misorientation between measurement points of 10° or more is regarded as a crystal grain boundary, and the KAM value is not measured at the crystal grain boundary.

The bcc metal may include an amorphous phase as long as the particle generation in the case where the metal material according to the present embodiment is used as a target can be suppressed.

The average crystal grain size of the metal material according to the present embodiment is preferably 200 μm or less, 100 μm or less or 70 μm or less. This helps suppress particle adhesion to a substrate when the metal material according to the present embodiment is used as a target. The average crystal grain size may be 10 μm or more or 30 μm or more. The average crystal grain size is preferably 10 μm or more and 200 μm or less, more preferably 10 μm or more and 100 μm or less, still more preferably 30 μm or more and 70 μm or less.

In the present embodiment, the average crystal grain size is an average value of crystal grain sizes that can be determined by a method in accordance with JIS G 0551:2020 and Appendix JC.

The relative density of the metal material according to the present embodiment is preferably 99.6% or more or 99.8% or more, and may be 100% or less, since the strength tends to be higher. The relative density is preferably 99.6% or more and 100% or less, more preferably 99.8% or more and 100% or less.

**EP 4 527 971 A1**

In the present embodiment, the term "relative density" refers to the ratio [%] of a measured density [g/cm$^3$] to a true density [g/cm$^3$]. The measured density is a mass [g] of the metal material measured by mass measurement with respect to a volume [cm$^3$] of the metal material measured by a method in accordance with JIS R 1634. The true density is a value determined from the following formula.

$$\rho_t = W_t/\{(W_1/\rho_1 + (W_2/\rho_2) + \ldots + (W_n/\rho_n)\}$$

In the above formula, $\rho_t$ is a true density [cm$^3$] of the metal material, and $W_t$ is a mass [g] of the metal material measured by mass measurement. $W_1$ to $W_n$ are mass ratios [g/g] of bcc metals contained in the metal material, and $\rho_1$ to $\rho_n$ are true densities [g/cm$^3$] of the bcc metals contained in the metal material. $W_1$ to $W_n$ are mass ratios of the bcc metals obtained by a composition analysis of the metal material, and the sum of $W_1$ to $W_n$ is 1.0. The true densities of the bcc metals are, for example, as follows: chromium, 7.19 g/cm$^3$; iron, 7.87 g/cm$^3$; rubidium, 1.53 g/cm$^3$; niobium, 8.57 g/cm$^3$; molybdenum, 10.22 g/cm$^3$; tantalum, 16.65 g/cm$^3$; vanadium, 6.0 g/cm$^3$; tungsten, 19.25 g/cm$^3$.

For example, the true density of 10 g of a metal material including a chromium-molybdenum alloy containing 60 mass% chromium and 40 mass% molybdenum is determined from the following formula.

$$\rho_t = 10/\{(0.6/7.19) + (0.4/10.22)\}$$

To suppress the generation of particles in the case where the metal material according to the present embodiment is used as a target, the metal material according to the present embodiment preferably contains less metal impurities. For example, the purity of the metal material according to the present embodiment is preferably more than 99.6%, 99.9% or more or 99.99% or more, and may be 100% or less or less than 100%. The purity of the metal material according to the present embodiment is preferably more than 99.6% and 100% or less, more preferably 99.9% or more and less than 100%. For the notation of purity in this specification, "4 N" represents a purity of 99.99% or more, and "5 N" represents a purity of 99.999% or more.

In the present embodiment, a metal impurity content is a content of metal impurities measured by glow discharge mass spectrometry (hereinafter also referred to as "GDMS") in accordance with ASTM F1593. Examples of the metal impurities include metals other than bcc metals, and in the case of a metal material formed of a specific bcc metal, the metal impurities are metals other than the specific bcc metal. For example, in the case of a chromium material and a chromium-molybdenum material, the metal impurities include metals other than chromium and molybdenum, and furthermore iron. A 10 to 25 mm $\times$ 10 to 25 mm $\times$ 0.5 to 15 mm prismatic metal material may be used as a measurement sample. Prior to the measurement, the measurement sample may be pretreated by polishing with SiC polishing paper (#800) to an Ra of 1.6 $\mu$m or less, followed by 10-minute ultrasonic cleaning in pure water, dehydration with alcohol, hot air drying and vacuum packaging.

The oxygen content of the metal material according to the present embodiment is preferably 200 mass ppm or less, preferably 150 mass ppm or less, 30 mass ppm or less or 10 mass ppm or less. This helps suppress generation of particles when the metal material according to the present embodiment is used as a sputtering target (hereinafter also referred to simply as a "target"). As long as the particle generation is suppressed, oxygen is allowed to be contained, and the oxygen content may be, for example, 0 mass ppm or more, more than 0 mass ppm, 1 mass ppm or more or 3 mass ppm or more. The oxygen content is preferably 0 mass ppm or more and 200 mass ppm or less, more preferably more than 0 mass ppm and 150 mass ppm or less, still more preferably 1 mass ppm or more and 30 mass ppm or less.

In the present embodiment, the oxygen content of the metal material can be measured with a commonly used oxygen/nitrogen analyzer (e.g., ON736 manufactured by LECO Corporation).

For each of the average KAM value, the average crystal grain size, the relative density, the purity and the oxygen content, the upper limit and the lower limit may be in any combination described above.

The metal material according to the present embodiment may have any shape but preferably has a shape suitable for sputtering, for example, at least one selected from the group consisting of a plate shape, a columnar shape and a cylindrical shape.

<Sputtering Target>

The metal material according to the present embodiment can be used for known applications of bcc metals, and is preferably used as a sputtering target, more preferably used as a metal material for a sputtering target.

A sputtering target comprising the metal material according to the present embodiment (hereinafter also referred to as a "target according to the present embodiment") may be made of the metal material according to the present embodiment, or may be a target comprising a backing plate and the metal material according to the present embodiment.

Hereinafter, the target according to the present embodiment will be described in the context of a target comprising a backing plate and the metal material according to the present embodiment.

The backing plate may be made of any material capable of conducting electricity and dissipating heat during sputtering, and may be, for example, a backing plate made of at least one selected from the group consisting of copper (Cu), aluminum (Al), titanium (Ti) and SUS (Steel Use Stainless).

In the target according to the present embodiment, the metal material is bonded to the backing plate. The metal material and the backing plate may be directly bonded to each other or may be bonded to each other through a bonding material. The bonding material may be a known material, such as indium (In).

In the target according to the present embodiment, the shape of the metal material may be any shape suitable for sputtering, for example, at least one selected from the group consisting of a plate shape, a columnar shape and a cylindrical shape.

In the target according to the present embodiment, the maximum difference in the orientation area of the {111} plane in the thickness direction of the bcc metal of the metal material (hereinafter also referred to as the "orientation difference$_{\{111\}}$") is 10% or less, preferably 0% or more, 2% or more or 5% or more. The orientation difference$_{\{111\}}$ is preferably 0% or more and 10% or less, more preferably 2% or more and 10% or less. The ratio of the maximum difference in the orientation area of the {111} plane to the sum of the maximum differences in the orientation areas of the {001} plane, the {101} plane and the {111} plane (hereinafter also referred to as the "orientation difference ratio") may be, for example, 0.4 or more or 0.5 or more and 0.8 or less. The orientation difference$_{\{111\}}$ and the orientation difference ratio are each an index that indicates a variation in the crystal orientation in the thickness direction in the target. When the orientation difference$_{\{111\}}$ and the orientation difference ratio are in the above ranges, changes in the crystalline state accompanying the progress of sputtering are reduced. This helps form a more uniform film.

For the same reason, the maximum difference in average crystal grain size in the thickness direction of the bcc metal of the metal material in the target according to the present embodiment (hereinafter also referred to simply as the "grain size difference") is preferably 30 μm or less or 10 μm or less. This reduces changes in particle generation behavior even if particles are generated. The grain size difference may be, for example, 0 μm or more, 1 μm or more or 3 μm or more. The grain size difference is preferably 0 μm or more and 30 μm or less, more preferably 1 μm or more and 10 μm or less, still more preferably 3 μm or more and 10 μm or less.

The orientation difference$_{\{111\}}$, the orientation difference ratio and the grain size difference may be determined in the following manner. Specifically, in the target according to the present embodiment, a direction perpendicular to a surface (hereinafter also referred to as a "sputtering surface") facing a surface (hereinafter also referred to as a "bonding surface") of the metal material bonded to the backing plate is regarded as the thickness direction. The target according to the present embodiment is cut in the thickness direction into three equal cut pieces, and exposed surfaces of the cut pieces on the sputtering surface side are subjected to the above-described SEM-EBSD measurement. From the orientation area fraction$_{\{111\}}$, the orientation area fraction$_{\{101\}}$, the orientation area fraction$_{\{001\}}$ and the difference in average crystal grain size obtained, the orientation difference$_{\{111\}}$, the orientation difference ratio and the grain size difference may be determined.

To achieve a larger deposition area, the area of the sputtering surface of the target according to the present embodiment is preferably 200 cm$^2$ or more, 350 cm$^2$ or more or 800 cm$^2$ or more. The area of the sputtering surface may be, for example, 1500 cm$^2$ or less or 1200 cm$^2$ or less.

<Method for Producing Metal Material>

The metal material according to the present embodiment may be produced by any method, and one example of a preferred production method is a method for producing the metal material, the method comprising a pressurization step of performing a pressurization treatment on an ingot formed of a metal having a body-centered cubic structure at a pressurizing temperature of 500°C or higher and a pressurizing rate of less than 15 mm/s to obtain a processed ingot, and a heat treatment step of heat treating the processed ingot at 850°C or higher.

In the pressurization step, a pressurization treatment is performed on an ingot formed of a metal having a body-centered cubic structure at a pressurizing temperature of 500°C or higher and a pressurizing rate of less than 15 mm/s to obtain a processed ingot.

The ingot to be subjected to the pressurization step may be any ingot formed of a metal having a body-centered cubic structure, and is preferably an ingot formed of at least one selected from the group consisting of chromium (Cr), iron (Fe), rubidium (Ru), niobium (Nb), molybdenum (Mo), tantalum (Ta), vanadium (V) and tungsten (W), more preferably an ingot formed of at least one selected from the group consisting of chromium, molybdenum, tantalum, vanadium and tungsten, still more preferably an ingot formed of at least one selected from the group consisting of chromium, molybdenum and tungsten, yet more preferably an ingot formed of at least one of chromium and molybdenum, particularly preferably an ingot formed of chromium.

The ingot may be an ingot formed of an alloy, and may be, for example, an ingot formed of an alloy containing at least one selected from the group consisting of chromium, iron, rubidium, niobium, molybdenum, tantalum, vanadium and tungsten, an ingot formed of an alloy containing at least one selected from the group consisting of chromium, molybdenum, tantalum, vanadium and tungsten, an ingot formed of an alloy containing at least one selected from the group consisting of chromium, molybdenum and tungsten, an ingot formed of an alloy containing chromium, an ingot formed of an alloy containing molybdenum or an ingot formed of an alloy containing chromium and molybdenum or a chromium-molybdenum alloy.

The ingot to be subjected to the pressurization step may have any purity as long as it has a composition equivalent to that of the desired metal material, and preferably has the same purity and oxygen content as those of the metal material described above.

The relative density of the ingot to be subjected to the pressurization step is preferably 99% or more or 99.5% or more. This helps provide a metal material with high strength. The relative density of the ingot may be, for example, 100% or less.

The ingot to be subjected to the pressurization step may have any average crystal grain size, preferably more than 200 μm or 300 μm or more. The average crystal grain size of the ingot may be 2000 μm or less, 1000 μm or less or 400 μm or less.

The ingot to be subjected to the pressurization step may have any orientation area fraction ratio, which may be less than 0.45 or 0.3 or less. The orientation area fraction ratio of the ingot is, for example, 0.1 or more.

In the pressurization step, the ingot is pressurized at a pressurizing temperature of 500°C or higher. At lower than 500°C, <111> slip is less likely to occur. The pressurizing temperature is preferably 600°C or higher or 700°C or higher. To suppress the occurrence of defects such as cracking during the pressurization treatment, the pressurizing temperature is preferably 1000°C or lower or 900°C or lower.

In the pressurization step, the pressurizing rate is less than 15 mm/s. When the pressurizing rate is 15 mm/s or more, the ingot is abruptly pressurized, so that the ingot is compressed without <111> slip. The pressurizing rate is preferably less than 15 mm/s or 10 mm/s or less, and may be 1 mm/s or more or 3 mm/s or more. The pressurizing rate is preferably 1 mm/s or more and less than 15 mm/s, more preferably 3 mm/s or more and 10 mm/s or less.

The method of the pressurization treatment may be any method by which pressure can be applied to the ingot, and may be, for example, at least one of forging, drawing, extrusion and rolling.

The pressurization treatment in the pressurization step is preferably performed twice or more, preferably performed three times or more. By performing the pressurization treatment under the above-described conditions a plurality of times, strain can be introduced without causing defects such as ingot cracking. As a result, a metal material having a high orientation area fraction ratio is readily provided. To help provide a metal material whose surface and interior are more uniformly structured, the pressurization treatment is preferably performed 20 times or less or 10 times or less. The pressurization treatment is preferably performed twice or more and 20 times or less, more preferably performed three times or more and 10 times or less.

The temperature of the ingot may decrease from before to after the pressurization treatment. When the pressurization treatment in the pressurization step is performed a plurality of times, for each pressurization treatment to be performed at the above-described pressurizing temperature, the ingot before each pressurization treatment may be heated to the pressurizing temperature before the subsequent pressurization treatment is performed.

The total rolling reduction of the processed ingot after the pressurization step is preferably 50% or more or 60% or more. The total rolling reduction may be determined from the following formula.

$$\text{Total rolling reduction [\%]} = (1 - \text{thickness of processed ingot/thickness of ingot before processing step}) \times 100$$

In the heat treatment step, the processed ingot is heat treated at 850°C or higher. This promotes recrystallization to form {111}-oriented crystal grains, providing the metal material according to the present embodiment.

The heat treatment is performed at 850°C or higher, preferably at 900°C or higher. At lower than 850°C, recrystallization is less likely to proceed. From the viewpoint of energy cost, the temperature of the heat treatment need not be higher than necessary, and may be 1300°C or lower or 1100°C or lower. The heat treatment is preferably performed at 850°C or higher and 1300°C or lower, more preferably performed at 900°C or higher and 1100°C or lower.

The heat treatment may be performed in any atmosphere, such as an oxidizing atmosphere, a reducing atmosphere or a vacuum atmosphere, and is preferably performed in an oxidizing atmosphere. For simplicity, the heat treatment atmosphere is more preferably an air atmosphere.

The heat treatment time may be appropriately adjusted according to the size of the processed ingot to be subjected to the heat treatment step, the performance of a heat treatment furnace, etc., and is, for example, 1 hour or more and 5 hours or less.

To provide a metal material with a desired shape, the production method according to the present embodiment may include, prior to the heat treatment step, a processing step of processing the processed ingot. The processing may be performed by any method, such as cutting.

To reduce the surface roughness of the metal material, the production method according to the present embodiment may include, after the heat treatment step, a surface treatment step of surface treating the metal material.

<Method for Producing Sputtering Target>

As the target according to the present embodiment, the metal material according to the present embodiment may be used as it is. Alternatively, the target according to the present embodiment can be produced by a production method including a bonding step of bonding the metal material according to the present embodiment to a backing plate.

The method of bonding in the bonding step may be any method by which the backing plate and the metal material can be bonded to each other, and is, for example, at least one selected from the group consisting of diffusion bonding, solder bonding and friction stir welding.

<Deposition Method>

The sputtering target comprising the metal material according to the present embodiment can be used for a method for producing a film, the method comprising using the sputtering target. The film is formed by sputtering.

The film may be produced by any method (deposition method), such as a method for producing a film under the following conditions. This provides a film, a thin film, a sputtered film or a bcc metal sputtered film.

Ultimate vacuum: $1 \times 10^{-4}$ Pa
Process gas: Ar
Gas pressure: 0.5 Pa
Deposition temperature: room temperature
Substrate: glass substrate
Discharge power: 10 W/cm$^2$
Deposition time: 60 sec

EXAMPLES

The present disclosure will now be described with reference to Examples. However, the following Examples are not intended to limit the present disclosure.

(Orientation Area Fraction)

The orientation area fractions of crystal planes were determined from an SEM observation image obtained by an SEM-EBSD measurement under the following conditions using an SEM-EBSD apparatus (apparatus name: JSM-IT800, manufactured by JEOL Ltd.), a measurement program (software name: AZtec) and an analysis program (software name: AZtec Crystal).

Observation magnification: $10\times$
Acceleration voltage condition: acceleration voltage, 20 kV
Applied current: 100 $\mu$A
Working distance: 10 mm
Step size: 5 $\mu$m

The SEM observation image was divided into 5 $\mu$m $\times$ 5 $\mu$m unit cells to determine lattice points, which were used as measurement points to measure the orientation planes and the areas thereof at all the measurement points, and the orientation area fraction$_{\{111\}}$ [%], the orientation area fraction$_{\{101\}}$ [%], the orientation area fraction$_{\{001\}}$ [%] and the orientation area fraction ratio were determined from the above-mentioned formulae.

As a measurement sample, a disc-shaped metal material having a diameter of 330 mm was used. Prior to the measurement, the measurement sample was cut in the thickness direction, and a cut surface obtained was used as a measurement surface. The measurement surface was pretreated by mirror polishing using SiC polishing paper and buffing, followed by electrolytic etching using a 5 vol% aqueous sulfuric acid solution. (Range distant from diameter center of measurement sample by 60 to 63 mm (3 mm wide)) $\times$ (thickness t of measurement sample) was defined as a measurement region, and the measurement region was subjected to the SEM-EBSD measurement.

(Orientation Difference$_{\{111\}}$ and Orientation Difference Ratio)

The orientation difference$_{\{111\}}$ was determined as follows: as a measurement sample, a metal material sample was cut in the thickness direction into three equal pieces, and for sputtering surfaces of the divided samples thus obtained and exposed surfaces of the cut pieces on the sputtering surface side, the orientation area fraction$_{\{111\}}$ [%] was determined in the same manner as described above, and its difference was determined.

In the same manner, the orientation area fraction$_{\{001\}}$ [%] and the orientation area fraction$_{\{101\}}$ [%] of the divided samples were determined, and the orientation difference ratio was determined.

(Oxygen Content)

The oxygen content was measured with an oxygen/nitrogen analyzer (apparatus name: ON736, manufactured by LECO Corporation). As a measurement sample, a metal material cut into a 4 mm $\times$ 4 mm $\times$ 5 mm prismatic shape was used.

(Average Crystal Grain Size)

The average crystal grain size of a target was calculated from the average line segment length per crystal grain of a line segment crossing crystal grains in an ingot structure in accordance with JIS G 0551:2020 and Appendix JC. For every crystal grain in the above observation area, the average crystal grain size ($\mu$m) was calculated.

(Grain Size Difference)

Average crystal grain sizes of three divided samples obtained in the same manner as for the orientation difference$_{\{111\}}$ were determined, and the difference between the maximum and minimum values thereof was determined as the grain size difference.

(Relative Density)

The measured density was measured by a method in accordance with JIS R 1634. From the ratio of the measured density with respect to the true density of a metal material sample obtained by the above-mentioned formula, the relative density [%] of the sample was determined.

(Average KAM Value)

Using the results obtained by the same SEM-EBSD measurement as the measurement of the orientation area fraction, KAM values were determined by the above-described method, and their average value was determined as the average KAM value.

Example 1

150 kg of chromium powder (purity, 4 N; oxygen content, 6 mass ppm) was enclosed in a 350 mm $\times$ 350 mm $\times$ 350 mm soft iron can and subjected to a HIP treatment under the following conditions.

HIP treatment atmosphere: argon gas atmosphere
HIP treatment temperature: 1150°C
HIP treatment pressure: 100 MPa
HIP treatment time: 2 hours

The resulting HIP-treated product was ground and cut to adjust its shape to obtain a disc-shaped ingot having a diameter of 180 mm and a thickness of 50 mm.

The ingot obtained was heated to 800°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 330 mm and a thickness of 15 mm (total rolling reduction, 70%). In repeating the pressurization treatment, when the temperature of the ingot after each pressurization treatment was 450°C or lower, the ingot was heated to 800°C before being subjected to the subsequent pressurization treatment.

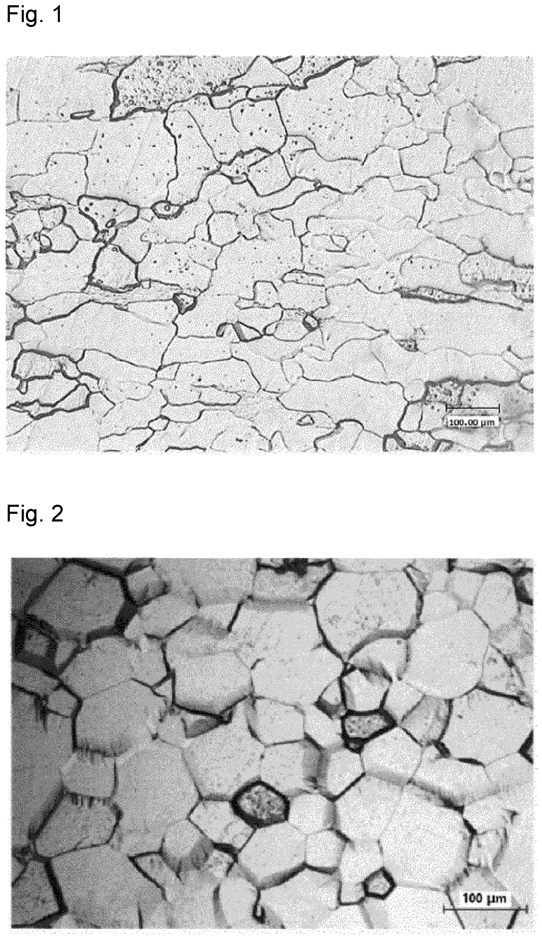

The processed ingot was treated at 1000°C for 1 hour in the atmosphere to obtain a disc-shaped chromium material having a diameter of 330 mm and a thickness of 15 mm, which was used as a chromium material of this Example (purity, 4 N; oxygen content, 6 mass ppm). Fig. 1 shows an optical microscopic observation image of a section of the chromium material of this Example.

Example 2

Except for using chromium powder (purity, 4 N; oxygen content, 15 mass ppm), the HIP treatment and the grinding and cutting were performed in the same manner as in Example 1 to obtain an ingot.

The ingot obtained was heated to 600°C, and the heated ingot was then subjected to a pressurization treatment in which pressure was applied in the thickness direction of the ingot at a pressurizing rate of 5 mm/s. The pressurization treatment was repeated four times to obtain an ingot (a processed ingot) having a diameter of 330 mm and a thickness of 15 mm (total rolling reduction, 70%). In repeating the pressurization treatment, when the temperature of the ingot after each pressurization treatment was 500°C or lower, the ingot was heated to 600°C before being subjected to the subsequent pressurization treatment.

The processed ingot was treated at 1100°C for 1 hour in the atmosphere to obtain a disc-shaped chromium material having a diameter of 330 mm and a thickness of 15 mm, which was used as a chromium material of this Example (purity, 4 N; oxygen content, 15 mass ppm).

Example 3

An ingot (a processed ingot) having a diameter of 330 mm and a thickness of 15 mm (total rolling reduction, 70%) was obtained in the same manner as in Example 2 except that when the temperature of the ingot after each pressurization treatment was 400°C or lower, the ingot was heated to 600°C before being subjected to the subsequent pressurization treatment and that the pressurization treatment was repeated eight times.

The processed ingot was treated at 1000°C for 2 hours in the atmosphere to obtain a disc-shaped chromium material having a diameter of 330 mm and a thickness of 15 mm, which was used as a chromium material of this Example (purity, 4 N; oxygen content, 15 mass ppm).

Example 4

Except for using chromium powder (purity, 4 N; oxygen content, 120 mass ppm), the HIP treatment and the grinding and cutting were performed in the same manner as in Example 1 to obtain an ingot.

The ingot obtained was heated to 850°C, and the heated ingot was then subjected to a pressurization treatment in which pressure was applied in the thickness direction of the ingot at a pressurizing rate of 5 mm/s. The pressurization treatment was repeated eight times to obtain an ingot (a processed ingot) having a diameter of 360 mm and a thickness of 12.5 mm (total rolling reduction, 75%). In repeating the pressurization treatment, when the temperature of the ingot after each pressurization treatment was 600°C or lower, the ingot was heated to 850°C before being subjected to the subsequent pressurization treatment.

The processed ingot was treated at 1000°C for 3 hours in the atmosphere to obtain a disc-shaped chromium material having a diameter of 360 mm and a thickness of 12.5 mm, which was used as a chromium material of this Example (purity, 4 N; oxygen content, 120 mass ppm).

Example 5

210 kg of molybdenum powder (purity, 5 N; oxygen content, 20 mass ppm) was enclosed in a 350 mm × 350 mm × 350 mm soft iron can and subjected to a HIP treatment under the following conditions.

HIP treatment atmosphere: argon gas atmosphere
HIP treatment temperature: 1250°C
HIP treatment pressure: 150 MPa
HIP treatment time: 5 hours

The resulting HIP-treated product was ground and cut to adjust its shape to obtain a disc-shaped ingot having a diameter of 180 mm and a thickness of 50 mm.

The ingot obtained was heated to 1000°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 330 mm and a thickness of 15 mm (total rolling reduction, 70%). In repeating the pressurization treatment, when the temperature of the ingot after each pressurization treatment was 800°C or lower, the ingot was heated to 800°C before being subjected to the subsequent pressurization treatment.

The processed ingot was treated at 1200°C for 1 hour in an argon atmosphere to obtain a disc-shaped molybdenum material having a diameter of 330 mm and a thickness of 15 mm, which was used as a molybdenum material of this Example (purity, 5 N; oxygen content, 10 ppm).

Example 6

210 kg of molybdenum powder (purity, 4 N; oxygen content, 100 mass ppm) was enclosed in a 350 mm × 350 mm × 350 mm soft iron can and subjected to a HIP treatment under the following conditions.

HIP treatment atmosphere: argon gas atmosphere
HIP treatment temperature: 1250°C
HIP treatment pressure: 150 MPa
HIP treatment time: 5 hours

The resulting HIP-treated product was ground and cut to adjust its shape to obtain a disc-shaped ingot having a diameter of 180 mm and a thickness of 50 mm.

The ingot obtained was heated to 1000°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 330 mm and a thickness of 15 mm (total rolling reduction, 70%). In repeating the pressurization treatment, when the temperature of the ingot after each pressurization treatment was 800°C or lower, the ingot was heated to 800°C before being subjected to the subsequent pressurization treatment.

The processed ingot was treated at 1200°C for 1 hour in an argon atmosphere to obtain a disc-shaped molybdenum material having a diameter of 330 mm and a thickness of 15 mm, which was used as a molybdenum material of this Example (purity, 4 N; oxygen content, 60 ppm). Fig. 2 shows an optical microscopic image of a section of the molybdenum material of this Example.

Example 7

210 kg of molybdenum powder (purity, 5 N; oxygen content, 20 mass ppm) was enclosed in a 350 mm × 350 mm × 350 mm soft iron can and subjected to a HIP treatment under the following conditions.

HIP treatment atmosphere: argon gas atmosphere
HIP treatment temperature: 1250°C
HIP treatment pressure: 150 MPa
HIP treatment time: 5 hours

The resulting HIP-treated product was ground and cut to adjust its shape to obtain a disc-shaped ingot having a diameter of 180 mm and a thickness of 50 mm.

The ingot obtained was heated to 1200°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 330 mm and a thickness of 15 mm (total rolling reduction, 70%). In repeating the pressurization treatment, when the temperature of the ingot after each pressurization treatment was 1000°C or lower, the ingot was heated to 1000°C before being subjected to the subsequent pressurization treatment.

The processed ingot was treated at 1300°C for 1 hour in an argon atmosphere to obtain a disc-shaped molybdenum material having a diameter of 330 mm and a thickness of 15 mm, which was used as a molybdenum material of this Example (purity, 5 N; oxygen content, 20 ppm).

Example 8

210 kg of molybdenum powder (purity, 4 N; oxygen content, 100 mass ppm) was enclosed in a 350 mm × 350 mm × 350 mm soft iron can and subjected to a HIP treatment under the following conditions.

HIP treatment atmosphere: argon gas atmosphere
HIP treatment temperature: 1250°C
HIP treatment pressure: 150 MPa
HIP treatment time: 5 hours

The resulting HIP-treated product was ground and cut to adjust its shape to obtain a disc-shaped ingot having a diameter of 180 mm and a thickness of 50 mm.

The ingot obtained was heated to 900°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 330 mm and a thickness of 15 mm (total rolling reduction, 70%). In repeating the pressurization treatment, when the temperature of the ingot after each pressurization treatment was 700°C or lower, the ingot was heated to 700°C before being subjected to the subsequent pressurization treatment.

The processed ingot was treated at 1200°C for 1 hour in an argon atmosphere to obtain a disc-shaped molybdenum material having a diameter of 330 mm and a thickness of 15 mm, which was used as a molybdenum material of this Example (purity, 4 N; oxygen content, 40 ppm).

Example 9

210 kg of molybdenum powder (purity, 5 N; oxygen content, 20 mass ppm) was enclosed in a 350 mm × 350 mm × 350 mm soft iron can and subjected to a HIP treatment under the following conditions.

HIP treatment atmosphere: argon gas atmosphere
HIP treatment temperature: 1250°C
HIP treatment pressure: 150 MPa
HIP treatment time: 5 hours

The resulting HIP-treated product was ground and cut to adjust its shape to obtain a disc-shaped ingot having a diameter of 180 mm and a thickness of 50 mm.

The ingot obtained was heated to 900°C, and the heated ingot was then subjected to a pressurization treatment in which pressure was applied in the thickness direction of the ingot at a pressurizing rate of 7 mm/s. The pressurization treatment was repeated eight times to obtain an ingot (a processed ingot) having a diameter of 400 mm and a thickness of 10 mm (total rolling reduction, 80%). In repeating the pressurization treatment, when the temperature of the ingot after each pressurization treatment was 700°C or lower, the ingot was heated to 700°C before being subjected to the subsequent pressurization treatment.

The processed ingot was treated at 1300°C for 1 hour in an argon atmosphere to obtain a disc-shaped molybdenum material having a diameter of 400 mm and a thickness of 10 mm, which was used as a molybdenum material of this Example (purity, 5 N; oxygen content, 20 ppm).

Example 10

Except for using chromium powder (purity, 4 N; oxygen content, 120 mass ppm), the HIP treatment and the grinding and cutting were performed in the same manner as in Example 1 to obtain an ingot.

The ingot obtained was heated to 850°C, and the heated ingot was then subjected to a pressurization treatment in which pressure was applied in the thickness direction of the ingot at a pressurizing rate of 5 mm/s. The pressurization treatment was repeated eight times to obtain an ingot (a processed ingot) having a diameter of 400 mm and a thickness of 10 mm (total rolling reduction, 80%). In repeating the pressurization treatment, when the temperature of the ingot after each pressurization treatment was 600°C or lower, the ingot was heated to 850°C before being subjected to the subsequent pressurization treatment.

The processed ingot was treated at 1200°C for 5 hours in the atmosphere to obtain a disc-shaped chromium material having a diameter of 400 mm and a thickness of 100 mm, which was used as a chromium material of this Example (purity, 4 N; oxygen content, 120 mass ppm).

Example 11

Except for using chromium powder (purity, 4 N; oxygen content, 120 mass ppm), the HIP treatment and the grinding and cutting were performed in the same manner as in Example 1 to obtain an ingot.

The ingot obtained was heated to 850°C, and the heated ingot was then subjected to a pressurization treatment in which pressure was applied in the thickness direction of the ingot at a pressurizing rate of 5 mm/s. The pressurization treatment was repeated eight times to obtain an ingot (a processed ingot) having a diameter of 400 mm and a thickness of 10 mm (total rolling reduction, 80%). In repeating the pressurization treatment, when the temperature of the ingot after each pressurization treatment was 800°C or lower, the ingot was heated to 850°C before being subjected to the subsequent pressurization treatment.

The processed ingot was treated at 1000°C for 5 hours in the atmosphere to obtain a disc-shaped chromium material having a diameter of 400 mm and a thickness of 100 mm, which was used as a chromium material of this Example (purity, 4 N; oxygen content, 120 mass ppm).

Comparative Example 1

Except for using chromium powder (purity, 4 N; oxygen content, 30 mass ppm), the HIP treatment and the grinding and cutting were performed in the same manner as in Example 1 to obtain an ingot.

The ingot obtained was heated to 800°C, and the heated ingot was then subjected to a pressurization treatment in which pressure was applied in the thickness direction of the ingot at a pressurizing rate of 15 mm/s. The pressurization treatment was repeated 48 times to obtain an ingot (a processed ingot) having a diameter of 330 mm and a thickness of 15 mm (total rolling reduction, 70%). In repeating the pressurization treatment, when the temperature of the ingot after each pressurization treatment was 450°C or lower, the ingot was heated to 800°C before being subjected to the subsequent pressurization treatment.

The processed ingot was treated at 800°C for 1 hour in the atmosphere to obtain a disc-shaped chromium material having a diameter of 330 mm and a thickness of 15 mm, which was used as a chromium material of this Comparative Example (purity, 4 N; oxygen content, 30 mass ppm).

Comparative Example 2

A HIP-treated product obtained in the same manner as in Example 1 was ground and cut into a disk shape having a diameter of 180 mm and a thickness of 50 mm to obtain an ingot. The ingot was used as a chromium material of this Comparative Example (purity, 4 N; oxygen content, 6 mass ppm).

Comparative Example 3

Except for using chromium powder (purity, 4 N; oxygen content, 15 mass ppm), the HIP treatment and the grinding and cutting were performed in the same manner as in Comparative Example 1 to obtain an ingot.

The ingot obtained was heated to 800°C, and the heated ingot was then subjected to a pressurization treatment in which pressure was applied in the thickness direction of the ingot at a pressurizing rate of 5 mm/s.

The pressurization treatment was repeated 32 times to obtain an ingot (a processed ingot) having a diameter of 232 mm and a thickness of 30 mm (total rolling reduction, 40%). In repeating the pressurization treatment, when the temperature of the ingot after each pressurization treatment was 450°C or lower, the ingot was heated to 800°C before being subjected to the subsequent pressurization treatment.

The processed ingot was treated at 1000°C for 1 hour in the atmosphere to obtain a disc-shaped chromium material having a diameter of 232 mm and a thickness of 30 mm, which was used as a chromium material of this Comparative Example (purity, 4 N; oxygen content, 15 mass ppm).

Comparative Example 4

Except for using chromium powder (purity, 4 N; oxygen content, 15 mass ppm), the HIP treatment and the grinding and cutting were performed in the same manner as in Comparative Example 1 to obtain an ingot.

The ingot obtained was heated to 850°C, and the heated ingot was then subjected to a pressurization treatment in which pressure was applied in the thickness direction of the ingot at a pressurizing rate of 5 mm/s. The pressurization treatment was repeated 24 times to obtain an ingot (a processed ingot) with a total rolling reduction of 70%.

In repeating the pressurization treatment, when the temperature of the ingot after each pressurization treatment was 450°C or lower, the ingot was heated to 850°C before being subjected to the subsequent pressurization treatment.

The processed ingot was treated at 1100°C for 1 hour in the atmosphere to obtain a disc-shaped chromium material having a diameter of 330 mm and a thickness of 15 mm, which was used as a chromium material of this Comparative Example (purity, 4 N; oxygen content, 15 mass ppm).

The evaluation results of the chromium materials and the molybdenum materials obtained in Examples and Comparative Examples are shown in the following table.

[Table 1]

| | Relative density [%] | Average grain size [μm] | Maximum difference in average grain size [μm] | Average KAM value [°] | Orientation area fraction [%] | | | Maximum difference in orientation area [%] | | | Ratio of orientation area fraction |
|---|---|---|---|---|---|---|---|---|---|---|---|
| | | | | | {001} | {101} | {111} | {001} | {101} | {111} | |
| Example 1 | 100 | 65.6 | 7.9 | 0.20 | 9.5 | 8.2 | 30.0 | 1.6 | 1.8 | 7.4 | 0.63 |
| Example 2 | 99.9 | 66.9 | 7.9 | 0.20 | 9.2 | 9.4 | 25.9 | 2.3 | 1.0 | 6.6 | 0.58 |
| Example 3 | 100 | 64.4 | 3.6 | 0.20 | 11.6 | 8.6 | 21.9 | 4.7 | 0.3 | 3.4 | 0.52 |
| Example 4 | 100 | 45.1 | 4.4 | 0.20 | 7.8 | 6.5 | 42.4 | 2.7 | 3.4 | 8.0 | 0.75 |
| Example 5 | 100 | 85.6 | 2.5 | 0.19 | 1.7 | 0.1 | 84.0 | 1.2 | 0.2 | 2.3 | 0.98 |
| Example 6 | 100 | 65.3 | 5.3 | 0.19 | 2.1 | 0.2 | 86.4 | 2.2 | 0.3 | 9.8 | 0.97 |
| Example 7 | 100 | 105.4 | 18.5 | 0.20 | 10.0 | 0.0 | 39.6 | 2.0 | 0.1 | 37.9 | 0.80 |
| Example 8 | 100 | 66.0 | 8.4 | 0.18 | 1.9 | 1.1 | 87.9 | 2.1 | 1.6 | 9.8 | 0.97 |
| Example 9 | 100 | 85.4 | 12.0 | 0.18 | 0.6 | 0.0 | 94.5 | 1.4 | 0.1 | 4.5 | 0.99 |
| Example 10 | 100 | 352.7 | 105.4 | 0.21 | 0.0 | 0.0 | 96.2 | 0.0 | 0.0 | 3.3 | 1.00 |
| Example 11 | 100 | 116 | 3.8 | 0.31 | 2.0 | 0.3 | 76.6 | 1.6 | 0.5 | 16.6 | 0.97 |
| Comparative Example 1 | 99.8 | 65.7 | 27.6 | 0.20 | 16.1 | 15.4 | 11.4 | 5.3 | 5.3 | 3.3 | 0.27 |
| Comparative Example 2 | 99.7 | 227.1 | 35.0 | 0.23 | 7.3 | 28.4 | 14.2 | 4.6 | 7.1 | 5.9 | 0.28 |
| Comparative Example 3 | 100 | 73.6 | 8.3 | 0.18 | 11.5 | 15.8 | 10.7 | 2.6 | 3.2 | 1.4 | 0.28 |
| Comparative Example 4 | 99.9 | 71.3 | 4.6 | 0.19 | 21.2 | 7.4 | 22.3 | 6.9 | 2.0 | 7.9 | 0.44 |

<Evaluation of Deposition Properties>

The chromium materials obtained in Examples and Comparative Examples were each machined and then bonded to an oxygen-free copper backing plate to obtain sputtering targets. Using the targets, sputtering was performed under the following conditions, and the deposition rate was measured. The results are shown in the following table.

Gas species: Ar
Gas pressure: 0.5 Pa
Power density: 7.4 W/cm$^2$
Deposition time: 60 s
Substrate: glass substrate (disc-shaped)
Substrate temperature: room temperature
Substrate rotation: none

The deposition rate was calculated by the following formula.

$$\text{Deposition rate [Å/s]} = \text{average film thickness [Å]}/\text{deposition time [s]}$$

In the above formula, the average film thickness is the average value of film thicknesses at measurement points, and the deposition time is 60 seconds. The measurement of the film thicknesses was performed at a total of 31 measurement points: (1) the center of a glass substrate after deposition (a glass substrate having a sputtered film), (2) 5 equally spaced points on the circumference of a concentric circle having a diameter equivalent to 1/4 of the diameter of the substrate, (3) 10 equally spaced points on the circumference of a concentric circle having a diameter equivalent to 2/4 of the diameter of the substrate and (4) 15 equally spaced points on the circumference of a concentric circle having a diameter equivalent to 3/4 of the diameter of the substrate. The film thickness at each measurement point was measured using a stylus profiler (apparatus name: Dektak XT, manufactured by Bruker). The average value of the obtained film thicknesses of the measurement points was determined as the average film thickness.

[Table 2]

|  | Deposition rate [Å/Sec] |
|---|---|
| Example 1 | 0.70 |
| Example 2 | 0.68 |
| Example 3 | 0.68 |
| Example 4 | 0.72 |
| Comparative Example 1 | 0.63 |
| Comparative Example 2 | 0.54 |

The present application is based on Japanese Patent Application (No. 2022-082420) filed on May 19, 2022 and Japanese Patent Application (No. 2022-140342) filed on September 2, 2022, the entire contents of which are incorporated herein by reference. All the references cited herein are incorporated in their entirety.

**Claims**

1. A metal material comprising a metal having a body-centered cubic structure, wherein with respect to a sum of orientation area fractions of a {001} plane, a {101} plane and a {111} plane, a ratio of the orientation area fraction of the {111} plane is 0.45 or more.

2. The metal material according to claim 1, comprising the metal having a body-centered cubic structure, wherein with respect to the sum of the orientation area fractions of the {001} plane, the {101} plane and the {111} plane, the ratio of the orientation area fraction of the {111} plane is 0.60 or more.

3. The metal material according to claim 1 or 2, wherein the orientation area fraction of the {111} plane of the metal is 20% or more.

4. The metal material according to any one of claims 1 to 3, wherein the orientation area fraction of the {111} plane of the metal is 80% or more.

5. The metal material according to any one of claims 1 to 4, wherein the orientation area fraction of the {001} plane of the metal is 20% or less.

6. The metal material according to any one of claims 1 to 5, wherein the orientation area fraction of the {001} plane of the metal is 5% or less.

7. The metal material according to any one of claims 1 to 6, wherein the metal has an average grain size of 200 $\mu$m or less.

8. The metal material according to any one of claims 1 to 7, wherein the metal having a body-centered cubic structure is at least one selected from the group consisting of chromium (Cr), iron (Fe), rubidium (Ru), niobium (Nb), molybdenum (Mo), tantalum (Ta), vanadium (V) and tungsten (W).

9. A method for producing the metal material according to any one of claims 1 to 8, the method comprising a pressurization step of performing a pressurization treatment on an ingot formed of a metal having a body-centered cubic structure at a pressurizing temperature of 500°C or higher and a pressurizing rate of less than 15 mm/s to obtain a processed ingot, and a heat treatment step of treating the processed ingot at 850°C or higher.

10. The production method according to claim 9, wherein the pressurization treatment in the pressurization step is performed twice or more.

11. A sputtering target comprising the metal material according to any one of claims 1 to 8.

12. A method for producing a film, the method comprising using a sputtering target comprising the metal material according to any one of claims 1 to 8.

Fig. 1

Fig. 2

<table>
<tr><td colspan="2">**INTERNATIONAL SEARCH REPORT**</td><td colspan="2">International application No.<br>**PCT/JP2023/018537**</td></tr>
</table>

**A. CLASSIFICATION OF SUBJECT MATTER**

*C23C 14/34*(2006.01)i; *B22F 3/15*(2006.01)i; *B22F 3/24*(2006.01)i; *C22F 1/00*(2006.01)i; *C22F 1/11*(2006.01)i; *C22F 1/18*(2006.01)i

FI: C23C14/34 A; B22F3/15 M; C22F1/11; C22F1/18 C; C22F1/00 606; C22F1/00 613; C22F1/00 694B; C22F1/00 694Z; B22F3/24 D

According to International Patent Classification (IPC) or to both national classification and IPC

**B. FIELDS SEARCHED**

Minimum documentation searched (classification system followed by classification symbols)

C23C14/34; B22F3/15; B22F3/24; C22F1/00; C22F1/11; C22F1/18

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | CN 110438350 A (XIAMEN TUNGSTEN CO., LTD.) 12 November 2019 (2019-11-12)<br>paragraphs [0018]-[0111] | 1, 3, 5-8 |
| X | JP 2009-528922 A (CABOT CORPORATION) 13 August 2009 (2009-08-13)<br>paragraphs [0009]-[0086] | 1-8, 11, 12 |
| A | | 9, 10 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 July 2023** | **08 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/018537**

| Patent document cited in search report | | | Publication date (day/month/year) | Patent family member(s) | Publication date (day/month/year) |
|---|---|---|---|---|---|
| CN | 110438350 | A | 12 November 2019 | (Family: none) | |
| JP | 2009-528922 | A | 13 August 2009 | US 2007/0209741 A1 paragraphs [0013]-[0079] KR 10-2008-0098414 A CN 101374611 A TW 200801214 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020195121 A
- JP 2022082420 A
- JP 2022140342 A